# EUROPEAN PATENT APPLICATION

(11) **EP 4 020 444 A1**
(43) Date of publication of application: **29.06.2022**
(21) Application number: 19932231.4
(22) Date of filing: 23.08.2019
(51) Int. Cl.: G09G 3/32

(54) **TEMPERATURE COMPENSATION METHOD FOR DISPLAY PANEL, DISPLAY PANEL, AND ELECTRONIC DEVICE**

(71) Applicant: BOE Technology Group Co., Ltd., Beijing 100015 (CN)
(72) Inventor: YANG, Shengji, Beijing 100176 (CN); CHEN, Xiaochuan, Beijing 100176 (CN); WANG, Hui, Beijing 100176 (CN); HUANG, Kuanta, Beijing 100176 (CN); LU, Pengcheng, Beijing 100176 (CN)
(74) Representative: Brötz, Helmut
(86) International application number: PCT/CN2019/102295
(87) International publication number: WO 2021/035407

(57) **Abstract**

A temperature compensation method for a display panel, a display panel, and an electronic device are disclosed. The display panel includes a pixel array, the pixel array includes a pixel unit, and the pixel unit includes a first voltage terminal and a second voltage terminal. The first voltage terminal is configured to receive a first power supply voltage, and the second voltage terminal is configured to receive a second power supply voltage. The pixel unit is configured to drive the light emitting element to emit light based on the first power supply voltage and the second power supply voltage that are received. The temperature compensation method for the display panel includes: setting a voltage difference between the second power supply voltage and the first power supply voltage as a first voltage difference, so as to enable a temperature of the display panel to rise, and setting the voltage difference between the second power supply voltage and the first power supply voltage as a second voltage difference after the temperature of the display panel rises. The first voltage difference is greater than the second voltage difference. The temperature compensation method for the display panel can effectively shorten the temperature rise time of the display panel, so that the temperature of the display panel reaches a stable temperature rapidly.

## Description

### TECHNICAL FIELD

Embodiments of the present disclosure relate to a temperature compensation method for a display panel, a display panel, and an electronic device.

### BACKGROUND

With the development of technologies, organic light emitting diode (OLED) display devices have gradually attracted widespread attention because of the advantages of wide viewing angle, high contrast ratio, fast response speed, as well as higher luminous brightness and lower drive voltage relative to inorganic light emitting display devices. Due to the above characteristics, the OLED may be applicable to a device having a display function, such as a mobile phone, a display, a notebook, a digital camera, an instrument, etc.

### SUMMARY

At least one embodiment of the present disclosure provides a temperature compensation method for a display panel. The display panel comprises a pixel array, the pixel array comprises a pixel unit, and the pixel unit comprises a light emitting element, a first voltage terminal, and a second voltage terminal. The first voltage terminal is configured to receive a first power supply voltage, and the second voltage terminal is configured to receive a second power supply voltage. The pixel unit is configured to drive the light emitting element to emit light based on the first power supply voltage and the second power supply voltage that are received. The temperature compensation method comprises: setting a voltage difference between the second power supply voltage and the first power supply voltage as a first voltage difference, so as to enable a temperature of the display panel to rise, and setting the voltage difference between the second power supply voltage and the first power supply voltage as a second voltage difference after the temperature of the display panel rises. The first voltage difference is greater than the second voltage difference.

For example, in the temperature compensation method provided by at least one embodiment of the present disclosure, setting the voltage difference between the second power supply voltage and the first power supply voltage as the first voltage difference, so as to enable the temperature of the display panel to rise, comprises: setting the first power supply voltage from an initial voltage value to a first voltage value, so as to enable the temperature of the display panel to rise, in which the initial voltage value is greater than the first voltage value. And setting the voltage difference between the second power supply voltage and the first power supply voltage as the second voltage difference after the temperature of the display panel rises comprises: setting the first power supply voltage from the first voltage value to a second voltage value after the temperature of the display panel rises, in which the first voltage value is less than the second voltage value.

For example, the temperature compensation method provided by at least one embodiment of the present disclosure further comprises: detecting a temperature variation amount of the temperature of the display panel relative to a first temperature value when the first power supply voltage is at the second voltage value, and compensating a voltage value of the first power supply voltage based on the temperature variation amount that is detected, so that the temperature of the display panel is maintained at the first temperature value.

For example, the temperature compensation method provided by at least one embodiment of the present disclosure further comprises: obtaining a data signal based on a predetermined gamma code, so that the display panel displays under drive of the data signal, the first power supply voltage, and the second power supply voltage.

For example, in the temperature compensation method provided by at least one embodiment of the present disclosure, the first voltage value and the second voltage value are both negative values.

For example, in the temperature compensation method provided by at least one embodiment of the present disclosure, a ratio of the second voltage value to the first voltage value ranges from 25% to 40%.

For example, in the temperature compensation method provided by at least one embodiment of the present disclosure, when the first power supply voltage is maintained at the first voltage value, the temperature of the display panel rises to a second temperature value.

For example, in the temperature compensation method provided by at least one embodiment of the present disclosure, a ratio of the second temperature value to the first temperature value ranges from 90% to 110%.

For example, in the temperature compensation method provided by at least one embodiment of the present disclosure, compensating the voltage value of the first power supply voltage based on the temperature variation amount that is detected comprises: converting the temperature variation amount that is detected into a voltage compensation amount, and generating, based on the voltage compensation amount, a compensation signal which is used for compensating the first power supply voltage, so that the voltage value of the first power supply voltage is adjusted.

For example, in the temperature compensation method provided by at least one embodiment of the present disclosure, the temperature of the display panel is detected by a temperature sensor which is provided in the display panel.

At least one embodiment of the present disclosure also provides a display panel. The display panel comprises a pixel array and a first power supply voltage providing circuit. The pixel array comprises a pixel unit, and the pixel unit comprises a light emitting element, a first voltage terminal, and a second voltage terminal. The first voltage terminal is configured to receive a first power supply voltage, and the second voltage terminal is configured to receive a second power supply voltage. The pixel unit is configured to drive the light emitting element to emit light based on the first power supply voltage and the second power supply voltage that are received. The first power supply voltage providing circuit is configured to set a voltage difference between the second power supply voltage and the first power supply voltage as a first voltage difference to enable a temperature of the display panel to rise, and to set the voltage difference between the second power supply voltage and the first power supply voltage as a second voltage difference after the temperature of the display panel rises. The first voltage difference is greater than the second voltage difference.

For example, the display panel provided by at least one embodiment of the present disclosure further comprises a temperature compensation circuit. The temperature compensation circuit comprises a temperature detection unit, a temperature conversion unit, and a compensation signal generating unit. The temperature detection unit is configured to detect a temperature variation amount of the temperature of the display panel relative to a first temperature value and output a voltage value corresponding to the temperature variation amount. The temperature conversion unit is configured to convert the voltage value corresponding to the temperature variation amount into a voltage compensation amount. The compensation signal generating unit is configured to process the voltage compensation amount to generate a compensation signal which is used for compensating the first power supply voltage, and provide the compensation signal to the first power supply voltage providing circuit. The first power supply voltage providing circuit is further configured to adjust a voltage value of the first power supply voltage based on the compensation signal.

For example, in the display panel provided by at least one embodiment of the present disclosure, the temperature detection unit comprises a temperature sensor.

For example, in the display panel provided by at least one embodiment of the present disclosure, the display panel comprises a silicon-based organic light emitting diode display panel or a silicon-based quantum dot light emitting diode display panel.

For example, the display panel provided by at least one embodiment of the present disclosure further comprises an array substrate. The array substrate comprises a silicon substrate, and the pixel unit further comprises a pixel circuit which is electrically connected to the light emitting element. The pixel circuit is provided on the silicon substrate.

For example, in the display panel provided by at least one embodiment of the present disclosure, the first power supply voltage providing circuit is provided on the silicon substrate.

At least one embodiment of the present disclosure also provides an electronic device, and the electronic device comprises the display panel described in any one of the embodiments of the present disclosure.

### BRIEF DESCRIPTION OF THE DRAWINGS

In order to more clearly illustrate the technical schemes of the embodiments of the present disclosure, the drawings of the embodiments will be briefly described in the following. It is obvious that the described drawings below are only related to some embodiments of the disclosure and are not limitative to the disclosure.
FIG. 1 is a voltage-brightness graph of a silicon-based OLED device at different temperatures;
FIG. 2A is a first schematic flow chart of a temperature compensation method for a display panel provided by at least one embodiment of the present disclosure;
FIG. 2B is a second schematic flow chart of a temperature compensation method for a display panel provided by at least one embodiment of the present disclosure;
FIG. 3 is a third schematic flow chart of a temperature compensation method for a display panel provided by at least one embodiment of the present disclosure;
FIG. 4 is a fourth schematic flow chart of a temperature compensation method for a display panel provided by at least one embodiment of the present disclosure;
FIG. 5 is a timing diagram and a temperature curve diagram of a temperature compensation method for a display panel provided by at least one embodiment of the present disclosure;
FIG. 6 is a schematic block diagram of a display panel provided by at least one embodiment of the present disclosure;
FIG. 7 is a schematic block diagram of a temperature compensation circuit of a display panel provided by at least one embodiment of the present disclosure;
FIG. 8 illustrates an exemplary circuit of a temperature detection unit according to at least one embodiment of the present disclosure;
FIG. 9 illustrates an exemplary circuit of a temperature conversion unit according to at least one embodiment of the present disclosure;
FIG. 10 is a schematic plane view of an array substrate of a display panel provided by at least one embodiment of the present disclosure;
FIG. 11A is a schematic circuit diagram of an array substrate of a display panel provided by at least one embodiment of the present disclosure;
FIG. 11B is a circuit diagram of a specific implementation example of a voltage control circuit and a pixel circuit of a display panel provided by at least one embodiment of the present disclosure;
FIG. 11C is a schematic cross sectional view of a display panel provided by at least one embodiment of the present disclosure; and
FIG. 12 is a schematic block diagram of an electronic device provided by at least one embodiment of the present disclosure.

### DETAILED DESCRIPTION

In order to make the objects, technical schemes and advantages of the embodiments of the present disclosure more clear, the technical schemes of the embodiments of the present disclosure will be described in a clear and full way in connection with the drawings. Obviously, the described embodiments are some embodiments of the present disclosure, not all embodiments. Based on the described embodiments of the present disclosure, all other embodiments obtained by those of ordinary skill in the art without the use of inventive faculty are within the scope of the present disclosure.

Unless otherwise defined, all the technical and scientific terms used herein have the same meanings as commonly understood by those of ordinary skill in the art to which the present disclosure belongs. The terms "first," "second," etc., which are used in the present disclosure, are not intended to indicate any sequence, amount or importance, but used to distinguish various components. Similarly, the terms, such as "a/an," "the," "one," etc., are not intended to indicate the limitation on amounts, but used to denote the presence of at least one. The terms, such as "comprise/comprising," "include/including," etc., are intended to specify that the elements or the objects stated before these terms encompass the elements or the objects and equivalents thereof listed after these terms, but not preclude other elements or objects. The terms, such as "connect/connecting/connected," "couple/coupling/coupled" etc., are not limited to a physical connection or mechanical connection, but may include an electrical connection/coupling, directly or indirectly. The terms, "on," "under," "left," "right," etc., are only used to indicate relative position relationship, and when the position of the object which is described is changed, the relative position relationship may be changed accordingly.

In order to keep the following description of embodiments of the present disclosure clear and concise, the detailed descriptions of known functions and known components are omitted from the present disclosure.

For example, a Micro-OLED display device is a kind of silicon-based OLED, which is a new type of OLED display device manufactured with a silicon substrate as a base substrate. The silicon-based OLED has the characteristics of small volume, high resolution and the like, and pixel circuits and other functional circuits can be manufactured in the silicon substrate. Therefore, the silicon-based OLED can be manufactured by adopting a mature complementary metal oxide semiconductor (CMOS) process for integrated circuits, so that the active addressing of pixels can be realized. The silicon-based OLED has various circuits such as timer control register (TCON), over current protection (OCP) circuit, etc., and can be lightweight. Thus the silicon-based OLED is widely used in the fields of near-eye display, virtual reality (VR), and augmented reality (AR), especially in AR/VR head-mounted display devices.

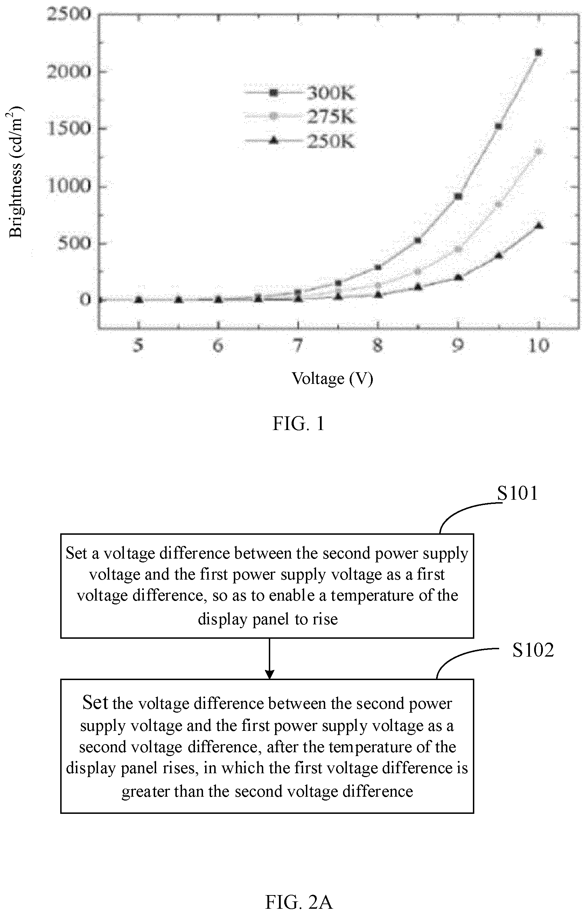

In the silicon-based OLED, the luminous brightness of the OLED device is greatly affected by the temperature factor. As illustrated in FIG. 1, under a same power supply voltage, the higher the temperature, the higher the luminous brightness of the OLED. In addition, as the temperature decreases, the threshold voltage of the OLED increases, the current density and the luminous brightness decrease, and the delay time of luminescence also increases obviously with the decrease of the temperature. Therefore, in order to ensure the high-quality display effect of the display panel, the temperature of the display panel needs to be compensated, so that the OLED can operate at an appropriate temperature.

At least one embodiment of the present disclosure provides a temperature compensation method for a display panel. The display panel comprises a pixel array, the pixel array comprises a pixel unit, and the pixel unit comprises a light emitting element, a first voltage terminal, and a second voltage terminal. The first voltage terminal is configured to receive a first power supply voltage, and the second voltage terminal is configured to receive a second power supply voltage. The pixel unit is configured to drive the light emitting element to emit light based on the first power supply voltage and the second power supply voltage that are received. The temperature compensation method comprises: setting a voltage difference between the second power supply voltage and the first power supply voltage as a first voltage difference, so as to enable a temperature of the display panel to rise, and setting the voltage difference between the second power supply voltage and the first power supply voltage as a second voltage difference after the temperature of the display panel rises. The first voltage difference is greater than the second voltage difference.

At least one embodiment of the present disclosure also provides a display panel. The display panel comprises a pixel array and a first power supply voltage providing circuit. The pixel array comprises a pixel unit, and the pixel unit comprises a light emitting element, a first voltage terminal, and a second voltage terminal. The first voltage terminal is configured to receive a first power supply voltage, and the second voltage terminal is configured to receive a second power supply voltage. The pixel unit is configured to drive the light emitting element to emit light based on the first power supply voltage and the second power supply voltage that are received. The first power supply voltage providing circuit is configured to set a voltage difference between the second power supply voltage and the first power supply voltage as a first voltage difference to enable a temperature of the display panel to rise, and to set the voltage difference between the second power supply voltage and the first power supply voltage as a second voltage difference after the temperature of the display panel rises. The first voltage difference is greater than the second voltage difference.

At least one embodiment of the present disclosure also provides an electronic device, and the electronic device comprises the display panel described above.

The temperature compensation method for a display panel, the display panel and the electronic device provided by at least one embodiment of the present disclosure described above can effectively shorten the temperature rise time of a display panel and an OLED in the display panel, and enable the temperature of the OLED to reach a temperature balance point as soon as possible, thereby ensuring the high-quality display effect.

The embodiments of the present disclosure and examples thereof are described in detail below with reference to the accompanying drawings. It should be noted that the same reference numerals in different drawings can be used to denote the same elements already described.

FIG. 2A is a first schematic flow chart of a temperature compensation method for a display panel provided by at least one embodiment of the present disclosure. For example, in at least one embodiment of the present disclosure, a display panel includes a pixel array, the pixel array includes a pixel unit, and the pixel unit includes a light emitting element, a first voltage terminal, and a second voltage terminal. The first voltage terminal is configured to receive a first power supply voltage, and the second voltage terminal is configured to receive a second power supply voltage. The pixel unit is configured to drive the light emitting element to emit light based on the first power supply voltage and the second power supply voltage that are received. As illustrated in FIG. 2A, the temperature compensation method includes following operations:
step S101: setting a voltage difference between the second power supply voltage and the first power supply voltage as a first voltage difference, so as to enable a temperature of the display panel to rise; and
step S102: setting the voltage difference between the second power supply voltage and the first power supply voltage as a second voltage difference after the temperature of the display panel rises, in which the first voltage difference is greater than the second voltage difference.

For example, in the temperature compensation method provided by at least one embodiment of the present disclosure, setting the voltage difference between the second power supply voltage and the first power supply voltage as the first voltage difference or the second voltage difference can be implemented in various ways. For example, under the condition that the first power supply voltage is not changed, only the voltage value of the second power supply voltage is adjusted, so that the difference described above becomes the first voltage difference or the second voltage difference. For another example, under the condition that the second power supply voltage is not changed, only the voltage value of the first power supply voltage is adjusted, so that the difference described above becomes the first voltage difference or the second voltage difference. For still another example, both the voltage value of the first power supply voltage and the voltage value of the second power supply voltage are adjusted, so that the difference described above becomes the first voltage difference or the second voltage difference. It should be noted that the setting manner of the first voltage difference value or the second voltage difference value can be set according to actual requirements and the specific structure of the pixel circuit, and the embodiments of the present disclosure are not limited thereto.

Through the above steps, the voltage difference between the cathode and the anode of the OLED device can be enlarged as soon as possible, and the maximum drive current of the OLED can be increased. Under the first voltage difference, the luminous brightness of the OLED device is higher, so the OLED device itself and the connected wires can generate and release more heat, so that the temperature of the display panel can be rapidly raised. After the temperature of the display panel rises to a predetermined range (e.g., close to a temperature balance point, and the temperature balance point is, for example, a preset empirical value), the voltage difference between the second power supply voltage and the first power supply voltage is set as the second voltage difference, and under the second voltage difference, the OLED of the display panel substantially maintains an initial brightness. Therefore, compared with conventional temperature compensation methods, this temperature compensation method can effectively shorten the temperature rise time of the display panel, so that the temperature of the display panel reaches a desired temperature range quickly, and the OLED devices arranged in the display panel can normally emit light at a predetermined temperature quickly, thereby ensuring the high-quality display effect of the display panel.

For example, in the temperature compensation method provided by at least one embodiment of the present disclosure, setting the voltage difference between the second power supply voltage and the first power supply voltage as the first voltage difference, so as to enable the temperature of the display panel to rise, includes: setting the first power supply voltage from an initial voltage value to a first voltage value, so that the temperature of the display panel rises, in which the initial voltage value is greater than the first voltage value. Setting the voltage difference between the second power supply voltage and the first power supply voltage as the second voltage difference after the temperature of the display panel rises includes: setting the first power supply voltage from the first voltage value to a second voltage value after the temperature of the display panel rises, in which the first voltage value is less than the second voltage value. For example, in this embodiment, the second power supply voltage remains unchanged.

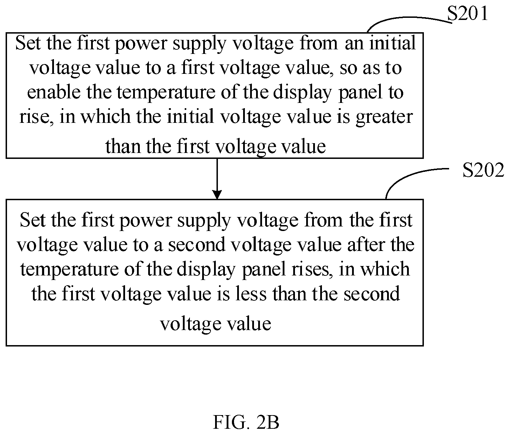

FIG. 2B is a second schematic flow chart of a temperature compensation method for a display panel provided by at least one embodiment of the present disclosure. For example, in at least one embodiment of the present disclosure, as illustrated in FIG. 2B, the temperature compensation method includes following operations:
step S201: setting the first power supply voltage from an initial voltage value to a first voltage value (e.g., the first power supply voltage is decreased from the initial voltage value to the first voltage value), so as to enable the temperature of the display panel to rise, in which the initial voltage value is greater than the first voltage value; and
step S202: setting the first power supply voltage from the first voltage value to a second voltage value after the temperature of the display panel rises, in which the first voltage value is less than the second voltage value.

Through the above steps, the voltage difference between the cathode and the anode of the OLED device can be enlarged as soon as possible, and the maximum drive current of the OLED can be increased. Under the first voltage value, the luminous brightness of the OLED device is higher, so the OLED device itself and the connected wires can generate and release more heat, so that the temperature of the display panel can be rapidly raised. After the temperature of the display panel rises to a predetermined range (e.g., close to a temperature balance point, and the temperature balance point is, for example, a preset empirical value), the first power supply voltage is set to a standard voltage value, i.e., the second voltage value. For example, the second voltage value is greater than the first voltage value. Under the second voltage value, the OLED of the display panel substantially maintains an initial brightness. Therefore, compared with conventional temperature compensation methods, this temperature compensation method can effectively shorten the temperature rise time of the display panel, so that the temperature of the display panel reaches a desired temperature range quickly, and the OLED devices arranged in the display panel can normally emit light at a predetermined temperature quickly, thereby ensuring the high-quality display effect of the display panel.

For example, in at least one embodiment of the present disclosure, the first voltage value and the second voltage value are both negative values, where the negative value can be understood as a negative value relative to a reference voltage (e.g., a ground voltage).

For example, in at least one embodiment of the present disclosure, in the case where the first voltage value and the second voltage value are both negative values, the ratio of the second voltage value to the first voltage value ranges from 25% to 40%. For example, within the above-described ratio range, the drive current flowing through the OLED can be prevented from being too large at either the first voltage value or the second voltage value, so that the OLED device can emit light safely and the situation of excessive brightness or damage can be avoided. Of course, the embodiments of the present disclosure are not limited thereto. The ratio range of the second voltage value to the first voltage value may also be set to other numerical ranges, which may be determined according to actual requirements, for example, according to the required temperature rise time. For example, in the case where the value of the first power supply voltage is set to the first voltage value, the less the first voltage value, the greater the voltage difference between the first power supply voltage and the second power supply voltage, the greater the drive current flowing through the OLED, the higher the brightness emitted by the OLED, the more the heat released, and accordingly, the shorter the temperature rise time of the display panel.

It should be noted that the embodiments of the present disclosure do not impose any limitation on the specific values of the first voltage value and the second voltage value, but in order to ensure the OLED device to emit light safely, the first voltage value cannot be set too low, so as not to cause the voltage difference between the cathode and the anode of the OLED device to be too large and the brightness of the display panel to be too high, thereby preventing the service life of the display panel from being affected.

For example, in at least one embodiment of the present disclosure, in the case where the first power supply voltage is maintained at the first voltage value, the temperature of the display panel rises to a second temperature value. For example, the second temperature value is equal to or approximately equal to a preset temperature balance point (i.e., a stable temperature value, i.e., the first temperature value hereinafter), or the difference between the second temperature value and the temperature balance point is within a preset range.

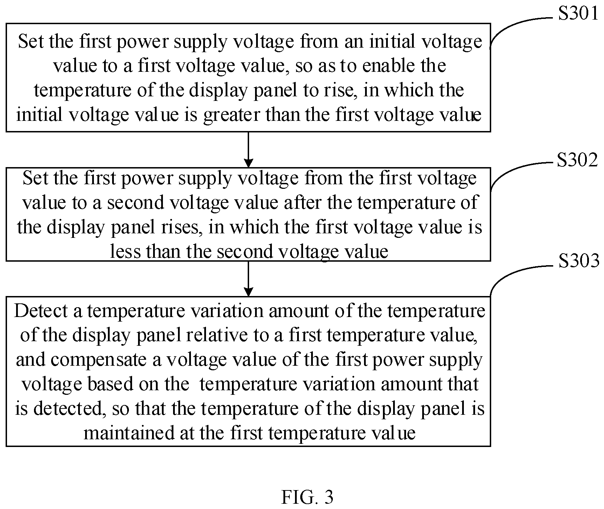

FIG. 3 is a third schematic flow chart of a temperature compensation method for a display panel provided by at least one embodiment of the present disclosure. For example, in at least one embodiment of the present disclosure, as illustrated in FIG. 3, the temperature compensation method includes following operations:
step S301: setting the first power supply voltage from an initial voltage value to a first voltage value, so as to enable the temperature of the display panel to rise, in which the initial voltage value is greater than the first voltage value;
step S302: setting the first power supply voltage from the first voltage value to a second voltage value after the temperature of the display panel rises, in which the first voltage value is less than the second voltage value; and
step S303: detecting a temperature variation amount of the temperature of the display panel relative to a first temperature value, and compensating a voltage value of the first power supply voltage based on the temperature variation amount that is detected, so that the temperature of the display panel is maintained at the first temperature value.

Because steps S301-S302 in FIG. 3 are similar to steps S201-S202 in FIG. 2, the detailed description of steps S301-S302 may be referred to the above description of steps S201-S202 in FIG. 2, which may not be repeated here.

In step S303, for example, the temperature of the display panel may be detected by a temperature sensor which is provided in the display panel, and then the detected temperature value is compared with the first temperature value to obtain the temperature variation amount, and therefore, the voltage value of the first power supply voltage can be compensated according to different temperature variation amounts, so that the temperature of the display panel is maintained at the first temperature value. For example, the first temperature value is a predetermined stable temperature value. For example, the compensation of the voltage value of the first power supply voltage is implemented by adjusting the voltage value of the first power supply voltage, so that the heating degree of the OLED device can be adjusted, and the temperature of the display panel can be further adjusted, so as to change the temperature of the display panel.

It should be noted that, in the embodiments of the present disclosure, there may be a plurality of temperature sensors in the display panel, the plurality of temperature sensors may be arranged at different positions in the pixel array of the display panel, and the detected temperature value may be the average value of the temperature values respectively detected by the plurality of temperature sensors, thereby improving the detection accuracy and reducing the detection error. The specific number of the plurality of temperature sensors is not limited, which may be determined according to actual requirements, for example, according to the size of the display panel, or the performance of the temperature sensors, and the embodiments of the present disclosure are not specifically limited thereto. Of course, in the embodiments of the present disclosure, there may be only one temperature sensor in the display panel, and the temperature sensor may be arranged at any position in the pixel array of the display panel, for example, at the center of the pixel array, thereby simplifying the manufacturing process and reducing the production cost.

The embodiments of the present disclosure have no limitation on the type of the temperature sensor, and for example, the temperature sensor may be a silicon-based diode, whereby the silicon-based diode can be integrally manufactured on a silicon substrate together with the pixel circuit. For example, the temperature sensor can be arranged on or at least partially formed in the silicon substrate, and the embodiments of the present disclosure are not limited thereto.

It should be noted that the embodiments of the present disclosure do not specifically limit the first temperature value and the second temperature value. The first temperature value may be greater than the second temperature value, may be equal to the second temperature value, or may be less than the second temperature value.

For example, in at least one embodiment of the present disclosure, a ratio of the second temperature value to the first temperature value ranges from 90% to 110%. That is, the first temperature value is relatively close to the second temperature value, and the difference between the two is small (for example, the difference between the two is ± 10%). For example, in at least one embodiment of the present disclosure, in the case where the ratio of the second temperature value to the first temperature value ranges from 90% to 110%, the temperature of the display panel can be quickly stabilized at the first temperature value (i.e., the stable temperature value) after rising to the second temperature value. It should be noted that in the embodiments of the present disclosure, the ratio range of the second temperature value to the first temperature value is not limited to the above-described specific range, but may be other appropriate ranges, which may be determined according to actual requirements, and the embodiments of the present disclosure are not limited thereto.

For example, in at least one embodiment of the present disclosure, compensating the first power supply voltage based on the temperature variation amount that is detected includes: converting the temperature variation amount that is detected into a voltage compensation amount, and generating, based on the voltage compensation amount, a compensation signal which is used for compensating the first power supply voltage, so that the voltage value of the first power supply voltage is adjusted.

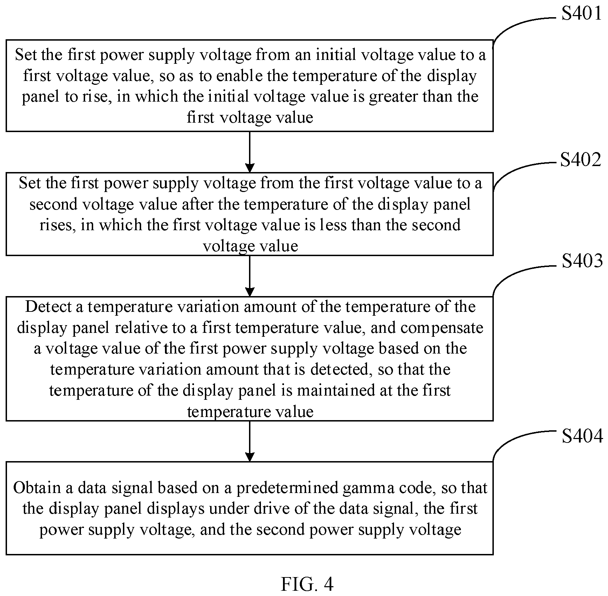

FIG. 4 is a fourth schematic flow chart of a temperature compensation method for a display panel provided by at least one embodiment of the present disclosure. For example, in at least one embodiment of the present disclosure, as illustrated in FIG. 4, the temperature compensation method includes following operations:
step S401: setting the first power supply voltage from an initial voltage value to a first voltage value, so as to enable the temperature of the display panel to rise, in which the initial voltage value is greater than the first voltage value;
step S402: setting the first power supply voltage from the first voltage value to a second voltage value after the temperature of the display panel rises, in which the first voltage value is less than the second voltage value;
step S403: detecting a temperature variation amount of the temperature of the display panel relative to a first temperature value, and compensating a voltage value of the first power supply voltage based on the temperature variation amount that is detected, so that the temperature of the display panel is maintained at the first temperature value; and
step S404: obtaining a data signal based on a predetermined gamma code, so that the display panel displays under drive of the data signal, the first power supply voltage, and the second power supply voltage, in which the first power supply voltage is less than the second power supply voltage.

Because steps S401-S403 in FIG. 4 are similar to steps S301-S303 in FIG. 3, the detailed description of steps S401-S403 may be referred to the above description of steps S301-S303 in FIG. 3, which may not be repeated here.

In step S404, a data signal is obtained based on a predetermined gamma code (e.g., a gamma code table, a gamma code function, etc.), so that the display panel displays under the drive of the data signal, the first power supply voltage, and the second power supply voltage. For example, in the case where the gamma value is in a range of 2.0-2.4, it meets the requirements of human eyes on the linear relationship between the brightness variation and gray scale variation. For example, in at least one embodiment of the present disclosure, the gamma value is set to 2.2 (the center value of the above-described range). In this embodiment, image information under the condition that the gamma value is 2.2 can be displayed in real time, but the embodiments of the present disclosure are not limited thereto, and the numerical value of the gamma value can be adjusted according to actual conditions.

For example, the display panel includes a pixel array which includes pixel units arranged in an array. The pixel unit includes a pixel circuit, a light emitting element, a first voltage terminal, and a second voltage terminal. The first power supply voltage is supplied to the cathode of the light emitting element (e.g., the first voltage terminal is electrically connected to the cathode of the light emitting element), and the second power supply voltage is applied to the anode of the light emitting element through the pixel circuit (e.g., the second voltage terminal is electrically connected to the pixel circuit). For example, after the temperature of the display panel is stable, the first power supply voltage may be a normal low-level power supply voltage VSS, and the second power supply voltage may be a normal high-level power supply voltage VDD.

It should be noted that in the above-described embodiments of the present disclosure, the temperature compensation method is not limited to the steps and sequences described above, this method may also include more steps, the sequences of the various steps may be determined according to actual requirements, and the embodiments of the present disclosure are not limited thereto.

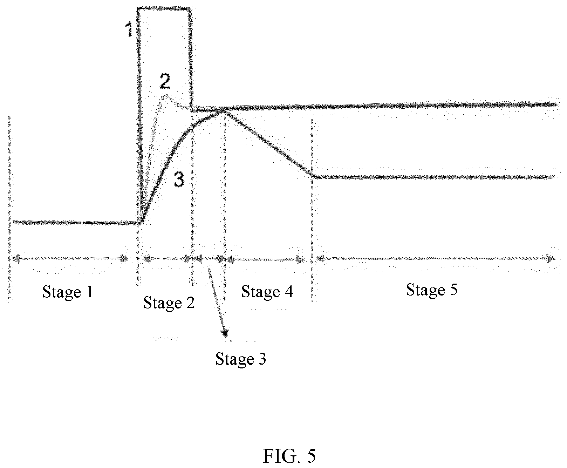

FIG. 5 is a timing diagram and a temperature curve diagram of a temperature compensation method for a display panel provided by at least one embodiment of the present disclosure. In FIG. 5, a solid line 1 represents a variation of the absolute value of the first power supply voltage with time (in this case, the first power supply voltage is a negative voltage), a solid line 2 represents a variation of the temperature of the display panel using the temperature compensation method provided by the embodiments of the present disclosure with time, and a solid line 3 represents a variation of the temperature of the display panel without using the temperature compensation method provided by the embodiments of the present disclosure with time.

For example, in at least one embodiment of the present disclosure, as illustrated in FIG. 5, the process of the temperature compensation of the display panel may include following five stages.

At stage 1 (initial stage), the first power supply voltage is an initial voltage value, and the temperature of the display panel is an initial temperature value. In this case, the display panel is in an initial state (i.e., not emitting light).

At stage 2 (temperature rising stage), the first power supply voltage is set to a first voltage value from the initial voltage value, and the temperature of the display panel rapidly rises to a second temperature value. For example, the second temperature value is close to a first temperature value. In this case, the voltage difference between the second power supply voltage and the first power supply voltage is a first voltage difference.

At stage 3 (voltage setting stage), the first power supply voltage is set from the first voltage value to a second voltage value, and the temperature of the display panel is substantially maintained at the first temperature value. In this case, the voltage difference between the second power supply voltage and the first power supply voltage is a second voltage difference, and the second voltage difference is less than the first voltage difference.

At stage 4 (temperature compensation stage), the first power supply voltage increases linearly from the second voltage value to a third voltage value, and the temperature of the display panel is substantially maintained at the first temperature value.

At stage 5 (temperature constant stage), the first power supply voltage is substantially maintained at the third voltage value, and the temperature of the display panel is substantially maintained at the first temperature value.

It should be noted that although in stage 4 (temperature compensation stage) illustrated in FIG. 5, the first power supply voltage increases linearly from the second voltage value to the third voltage value, the embodiments of the present disclosure are not limited thereto, and the first power supply voltage may also increase from the second voltage value to the third voltage value in a non-linear manner.

It should be noted that, in the embodiments of the present disclosure, although the temperature of the display panel maintains substantially stable and is substantially equal to the first temperature value (i.e., the preset stable temperature value) at stages 3, 4, and 5, as illustrated in FIG. 5, the embodiments of the present disclosure are not limited thereto, and the temperature of the display panel may also fluctuate around the first temperature value. For example, the temperature fluctuates in a small range around the first temperature value and gradually tends to be stable.

According to the solid line 2 in FIG. 5, it can be seen that, by using the temperature compensation method provided by the embodiments of the present disclosure, the temperature of the display panel is substantially at a stable temperature value (i.e., the first temperature value) at the end of stage 2, while according to the solid line 3 in FIG. 5, it can be seen that, without using the temperature compensation method provided by the embodiments of the present disclosure, the temperature of the display panel is substantially at a stable temperature value (i.e., the first temperature value) at the end of stage 3. By comparing the solid line 2 with the solid line 3, it can be seen that the temperature compensation method for the display panel provided by the embodiments of the disclosure can effectively shorten the temperature rise time of the display panel, so that the temperature of the display panel reaches a stable temperature rapidly, and the OLED devices arranged in the display panel can normally emit light at the stable temperature quickly, thereby ensuring the high-quality display effect of the display panel.

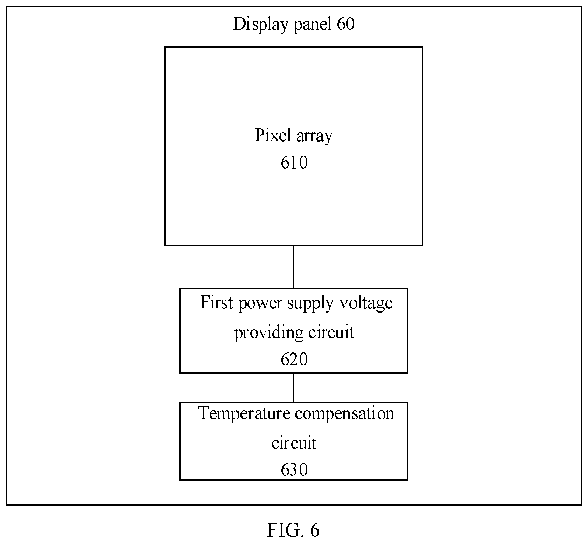

FIG. 6 is a schematic block diagram of a display panel provided by at least one embodiment of the present disclosure. For example, in at least one embodiment of the present disclosure, as illustrated in FIG. 6, a display panel 60 includes a pixel array 610 and a first power supply voltage providing circuit 620. The pixel array 610 is configured to receive a first power supply voltage and a second power supply voltage for display. The pixel array 610 includes pixel units arranged in an array. The pixel unit includes a light emitting element, a first voltage terminal, and a second voltage terminal. The first voltage terminal is configured to receive the first power supply voltage, and the second voltage terminal is configured to receive the second power supply voltage. The pixel unit is configured to drive the light emitting element to emit light based on the first power supply voltage and the second power supply voltage that are received. The first power supply voltage providing circuit 620 is configured to set a voltage difference between the second power supply voltage and the first power supply voltage as a first voltage difference to enable a temperature of the display panel 60 to rise, and to set the voltage difference between the second power supply voltage and the first power supply voltage as a second voltage difference after the temperature of the display panel 60 rises. The first voltage difference is greater than the second voltage difference.

For example, in some examples, the first power supply voltage providing circuit 620 is configured to set the first power supply voltage to a first voltage value to enable the temperature of the display panel to rise, and to set the first power supply voltage to a second voltage value after the temperature of the display panel rises. The first voltage value is less than the second voltage value. For example, the display panel 60 can perform temperature compensation by using the temperature compensation method provided by any embodiment of the present disclosure.

For example, in at least one embodiment of the present disclosure, as illustrated in FIG. 6, the display panel 60 further includes a temperature compensation circuit 630. The temperature compensation circuit 630 is configured to detect a temperature variation amount of the temperature of the display panel 60 relative to a first temperature value, compensate a voltage value of the first power supply voltage based on the temperature variation amount that is detected, and adjust the voltage value of the first power supply voltage, so that the temperature of the display panel 60 is maintained at the first temperature value.

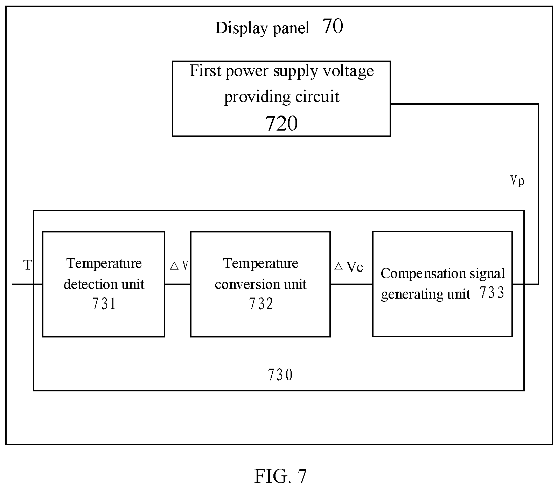

FIG. 7 is a schematic block diagram of a temperature compensation circuit of a display panel provided by at least one embodiment of the present disclosure. For example, in at least one embodiment of the present disclosure, the temperature compensation circuit 730 may include a temperature detection unit 731, a temperature conversion unit 732, and a compensation signal generating unit 733. For example, the temperature detection unit 731, the temperature conversion unit 732, and the compensation signal generating unit 733 may be implemented as sub-circuits of the temperature compensation circuit 730. The temperature detection unit 731 is configured to detect a temperature variation amount of the temperature T of the display panel 70 relative to the first temperature value and output a voltage value corresponding to the temperature variation amount. The temperature conversion unit 732 is configured to convert the voltage value corresponding to the detected temperature variation amount into a voltage compensation amount △Vc. The compensation signal generating unit 733 is configured to process the voltage compensation amount △Vc to generate a compensation signal Vp that is used for compensating the first power supply voltage of the display panel 70, and provide the compensation signal Vp to the first power supply voltage providing circuit 720. The first power supply voltage providing circuit 720 is further configured to adjust a voltage value of the first power supply voltage based on the compensation signal Vp. For example, the compensation signal Vp can control the voltage value of the first power supply voltage output by the first power supply voltage providing circuit 720.

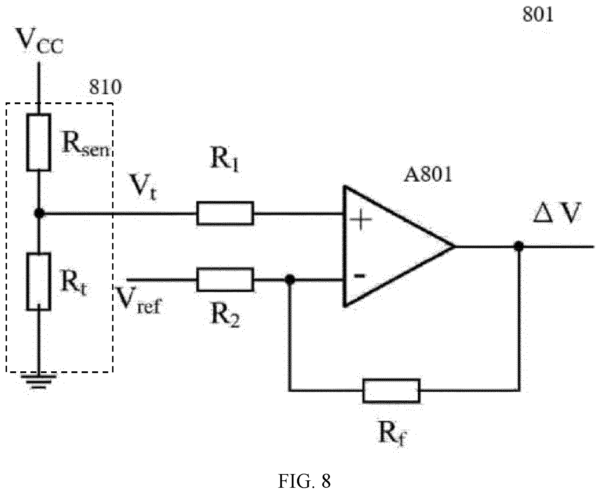

FIG. 8 illustrates an exemplary circuit of a temperature detection unit provided by at least one embodiment of the present disclosure. For example, in at least one embodiment of the present disclosure, a temperature detection unit 801 includes a temperature sensor 810. As illustrated in FIG. 8, the temperature detection unit 801 may include the temperature sensor 810 and a resistor divider Rt. For example, the temperature sensor 810 is a thermistor Rsen and is arranged on a flexible printed circuit (FPC) board that provides a drive signal to a display panel. One terminal of the thermistor is connected to a reference voltage Vcc, and the other terminal of the thermistor is grounded through the resistor divider Rt. A voltage value Vt can be obtained through the voltage divider circuit. It can be seen that the variation of the voltage value Vt represents the variation of resistance of the thermistor, and further represents the variation of the temperature.

It should be noted that in the above circuit, the thermistor may have a negative temperature coefficient (NPC), and the resistance of the thermistor decreases as the temperature increases. Alternatively, according to actual requirements, the thermistor may also have a positive temperature coefficient (PTC), and the resistance of the thermistor increases as the temperature increases. The embodiments of the present disclosure are not limited thereto.

For example, in at least one embodiment of the present disclosure, the voltage value Vt may be compared with a reference voltage value Vref, so as to obtain the variation amount of the voltage value Vt: △V = K(Vt-Vref), thereby directly representing the temperature variation amount △T, and for example, K is a fixed constant. For example, the reference voltage value Vref may correspond to the first temperature value described above, that is, in the case where the temperature sensed by the thermistor Rsen is the first temperature value, the voltage value Vt satisfies: Vt=Vref. For example, as illustrated in FIG. 8, by using a difference circuit implemented by an operational amplifier A801, the voltage variation amount corresponding to a temperature variation value can be obtained according to the sensed voltage value of the thermistor. For example, the voltage value Vt is connected to a non-inverting input terminal of the operational amplifier A801 through a resistor R1, the reference voltage value Vref is connected to an inverting input terminal of the operational amplifier A801 through a resistor R2, and an output terminal of operational amplifier A801 is connected to the inverting input terminal of the operational amplifier A801 through a feedback resistor Rf. According to the principle of the operational amplifier, the formula of △V=K(Vt-Vref) can be satisfied by selecting the resistances of R2 and Rf.

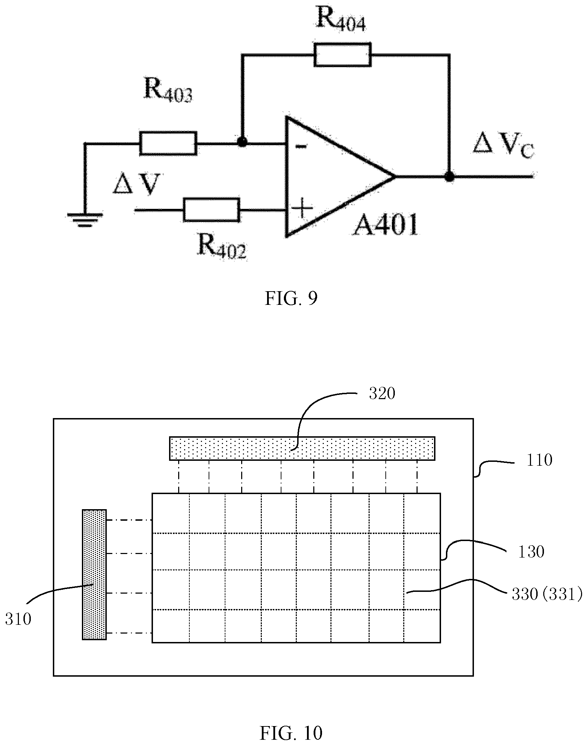

FIG. 9 illustrates a schematic circuit of a temperature conversion unit according to at least one embodiment of the present disclosure. For example, the temperature conversion unit is implemented by an operational amplifier A401 that is configured as a non-inverting amplifier. For example, a non-inverting input terminal of the operational amplifier A401 is configured to receive a voltage signal output from the temperature detection unit 801 through a resistor R402, and an inverting input terminal of the operational amplifier A401 is connected to an output terminal of the operational amplifier A401 through a resistor feedback network (R403 and R404). By using the temperature conversion unit described above, the impedance transformation and signal isolation can be implemented, and the detection signal of the temperature detection unit can also be amplified. For example, an output signal of the temperature conversion unit is: △Vc=△V(1+R404/R403).

Although FIG. 8 and FIG. 9 respectively illustrate an exemplary circuit of a temperature detection unit and a temperature conversion unit of the embodiments of the present disclosure, the temperature detection unit and the temperature conversion unit of the present disclosure include, but are not limited to, such circuits. For example, in the temperature detection unit, a temperature sensor may also be manufactured by using polysilicon, and may be arranged on a thin film transistor (TFT) side inside a display panel, so as to detect a temperature variation inside the display panel. In addition to the non-inverting operational circuit illustrated in FIG. 9, the temperature conversion unit may be implemented by, for example, an inverting operational circuit, a differential operational circuit, or the like, so as to convert the temperature variation amount into the voltage compensation amount, and also implement the impedance transformation and signal isolation. The specific circuit structure is not described in detail here.

For example, in at least one embodiment of the present disclosure, the compensation signal generating unit may include one or more of an addition compensation sub-unit, a subtraction compensation sub-unit, a multiplication compensation sub-unit, a division compensation sub-unit, and the like, and may select, according to a control signal received by the control terminal of the compensation signal generating unit, a corresponding compensation sub-unit to process the voltage compensation amount output by the temperature conversion unit, so as to generate a corresponding compensation signal. For example, the control signal may be a digital signal input from the outside of the temperature compensation circuit, and the embodiments of the present disclosure are not limited thereto. According to the principles of the present disclosure, those skilled in the art can, for example, provide a corresponding an exponential compensation sub-unit, a logarithmic compensation sub-unit, or the like, in the compensation signal generating unit according to the actually determined functional relationship, for example, an exponential function, a logarithmic function, etc., between the temperature of the display panel and the corresponding first power supply voltage value. The specific circuit structure of the compensation signal generating unit may be referred to conventional designs and is not described in detail here. For example, the functional relationship between the temperature of the display panel and the first power supply voltage value can be calculated according to theory or be obtained through actual tests, and the embodiments of the present disclosure are not limited to this case.

For example, in the display panel provided by at least one embodiment of the present disclosure, the pixel array includes pixel units arranged in an array, the pixel unit includes a pixel circuit, a light emitting element, a first voltage terminal, and a second voltage terminal, and the pixel circuit is electrically connected to the light emitting element. A first power supply voltage is applied to a cathode of the light emitting element (e.g., the first voltage terminal is electrically connected to the cathode of the light emitting element), a second power supply voltage is applied to an anode of the light emitting element through the pixel circuit (e.g., the second voltage terminal is electrically connected to the pixel circuit), and the light emitting element emits light according to the required gray scale under the collective functions of the first power supply voltage, the second power supply voltage, and a data signal provided separately.

FIG. 10 is a schematic plane view of a display panel provided by at least one embodiment of the present disclosure. For example, as illustrated in FIG. 10, the display panel includes an array substrate 110, the array substrate 110 includes a gate drive circuit 310, a data drive circuit 320, and a plurality of pixel units 330 arranged in an array, and the pixel unit 330 includes a cathode 331. For example, in some examples, cathodes 331 of the plurality of pixel units 330 are integrally formed, so as to form a common cathode structure. For example, the first power supply voltage is supplied to the cathode 331. The gate drive circuit 310 is configured to provide gate scanning signals to the plurality of pixel units 330, and the data drive circuit 320 is configured to provide data signals to the plurality of pixel units 330.

For example, in at least one embodiment of the present disclosure, the display panel may include a silicon-based organic light emitting diode display panel or a silicon-based quantum dot light emitting diode display panel.

For example, the display panel provided by at least one embodiment of the present disclosure includes an array substrate. The array substrate includes a silicon substrate, and the pixel circuit in the pixel array can be arranged on the silicon substrate or at least partially formed in the silicon substrate.

For example, in at least one embodiment of the present disclosure, the first power supply voltage providing circuit may be arranged on or at least partially formed in the silicon substrate, so as to simplify the structure of the display panel. Of course, the first power supply voltage providing circuit may also be arranged at any appropriate position in the display panel, may be integrated into one component with other circuits in the display panel, or may be a component provided separately, and the embodiments of the present disclosure are not limited thereto.

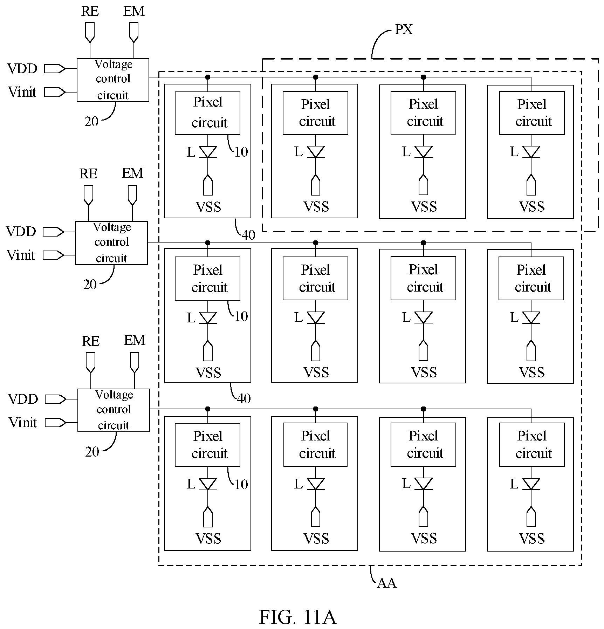

FIG. 11A is a schematic circuit diagram of an array substrate of a display panel provided by at least one embodiment of the present disclosure. The array substrate includes a plurality of light emitting elements L in a display region (AA region) and pixel circuits 10 which are coupled to the light emitting elements L in a one-to-one correspondence, and the pixel circuit 10 includes a drive transistor. The array substrate includes a silicon substrate, and the pixel circuit 10 is manufactured in the silicon substrate by using a semiconductor process. In addition, the array substrate may further include a plurality of voltage control circuits 20 in a non-display region (the region other than the display region in the array substrate) of the array substrate. For example, at least two pixel circuits 10 in a same row share one voltage control circuit 20, and first electrodes of the drive transistors in a same row of pixel circuits 10 are coupled to the shared voltage control circuit 20, and a second electrode of each drive transistor is coupled to a corresponding light emitting element L. The voltage control circuit 20 is configured to output an initialization signal Vinit to the first electrode of the drive transistor in response to a reset control signal RE for controlling the reset of the corresponding light emitting element L, and is configured to output a power supply signal VDD to the first electrode of the drive transistor in response to a light emission control signal EM for driving the light emitting element L to emit light. By sharing the voltage control circuit 20, the structure of each pixel circuit in the display region can be simplified, and the occupied area of the pixel circuits in the display region can be reduced, so that the display region can be provided with more pixel circuits and more light emitting elements, and an organic light emitting display panel with high PPI can be realized. In addition, the voltage control circuit 20 outputs the initialization signal Vinit to the first electrode of the drive transistor under the control of the reset control signal RE, so as to control the reset of the corresponding light emitting element, thereby avoiding the influence of the voltage applied to the light emitting element during the light emission of the previous frame on the light emission of the next frame, and further alleviating the afterimage phenomenon.

For example, the array substrate may further include a plurality of pixel units PX in the display region, and each pixel unit PX includes a plurality of sub-pixels. Each sub-pixel includes a light emitting element L and a pixel circuit 10, respectively. Further, the pixel unit PX may include 3 sub-pixels of different colors. The 3 sub-pixels may be a red sub-pixel, a green sub-pixel, and a blue sub-pixel, respectively. Of course, the pixel unit PX may also include 4, 5 or more sub-pixels, which needs to be designed and determined according to actual applications and is not limited here.

For example, pixel circuits 10 in at least two adjacent sub-pixels in a same row may share one voltage control circuit 20. For example, in some examples, as illustrated in FIG. 11A, all the pixel circuits 10 in the same row may share one voltage control circuit 20. Alternatively, in some other examples, pixel circuits 10 in two, three or more adjacent sub-pixels in a same row may share one voltage control circuit 20, which is not limited here. In this way, the occupied area of the pixel circuits in the display region can be reduced by sharing the voltage control circuit 20.

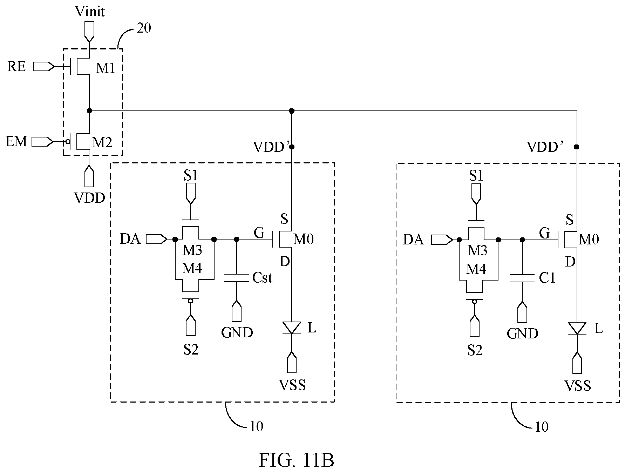

FIG. 11B is a circuit diagram of a specific implementation example of a voltage control circuit and a pixel circuit of a display panel provided by at least one embodiment of the present disclosure. For example, a drive transistor M0 in a pixel circuit 10 may be an N-type transistor (for example, an N-type MOS transistor). A first terminal S of the drive transistor M0 may serve as a source electrode, and a second terminal D of the drive transistor M0 may serve as a drain electrode, in the case where a current flows from the first terminal S to the second terminal D. The second terminal D may serve as a source electrode, and the first terminal S may serve as a drain electrode, in the case where the current flows from the second terminal D to the first terminal S. For example, in this embodiment, the first terminal S of the drive transistor M0 serves as a second voltage terminal VDD' of the pixel unit that includes this pixel circuit 10, and is configured to receive a high-level signal provided by the power supply signal VDD through the voltage control circuit 20. The light emitting element L may include an OLED. Thus, an anode of the OLED is electrically connected to the second terminal D of the drive transistor M0, and a cathode of the OLED is electrically connected to a first voltage terminal VSS. For example, the first voltage terminal VSS is the first voltage terminal of a pixel unit that includes this pixel circuit 10. For example, the first power supply voltage is supplied to the first voltage terminal VSS, so that the temperature of the display panel is changed by adjusting the voltage value of the first power supply voltage, and meanwhile, the OLED emits light under the action of the first power supply voltage (i.e., VSS), the power supply signal VDD, and a data signal DA. The voltage of the initialization signal Vinit may be set to a ground voltage VGND, which is not limited here. For example, the OLED can be set as a Micro-OLED or a Mini-OLED, which is further beneficial to realizing an organic light emitting display panel with high PPI.

For example, taking two pixel circuits 10 included in a same row as an example, the voltage control circuit 20 may include a first switching transistor M1 and a second switching transistor M2. A gate electrode of the first switching transistor M1 is used for receiving a reset control signal RE, a first electrode of the first switching transistor M1 is used for receiving an initialization signal Vinit, and a second electrode of the first switching transistor M1 is coupled to a first electrode S of the corresponding drive transistor M0. Agate electrode of the second switching transistor M2 is used for receiving a light emission control signal EM, a first electrode of the second switching transistor M2 is used for receiving a power supply signal VDD, and a second electrode of the second switching transistor M2 is coupled to the first electrode S of the corresponding drive transistor M0.

For example, the types of the first switching transistor M1 and the second switching transistor M2 may be different. For example, the first switching transistor M1 is an N-type transistor (for example, an N-type MOS transistor) and the second switching transistor M2 is a P-type transistor (for example, a P-type MOS transistor). Alternatively, the first switching transistor M1 is a P-type transistor and the second switching transistor M2 is an N-type transistor. Of course, the first switching transistor M1 and the second switching transistor M2 may be of a same type. In actual applications, the types of the first switching transistor M1 and the second switching transistor M2 need to be designed according to the actual application environment, which are not limited here.

For example, the pixel circuit 10 may further include a third switching transistor M3 and a storage capacitor Cst. For example, a gate electrode of the third switching transistor M3 is used to receive a first gate scanning signal S1, a first electrode of the third switching transistor M3 is used to receive a data signal DA, and a second electrode of the third switching transistor M3 is coupled to a gate electrode G of the drive transistor M0. A first terminal of the storage capacitor Cst is coupled to the gate electrode G of the drive transistor M0, and a second terminal of the storage capacitor Cst is coupled to a ground terminal GND

For example, the pixel circuit 10 may further include a fourth switching transistor M4. For example, a gate electrode of the fourth switching transistor M4 is used to receive a second gate scanning signal S2, a first electrode of the fourth switching transistor M4 is used to receive the data signal DA, and a second electrode of the fourth switching transistor M4 is coupled to the gate electrode G of the drive transistor M0. And the fourth switching transistor M4 and the third switching transistor M3 are of different types. For example, the third switching transistor M3 is an N-type transistor and the fourth switching transistor M4 is a P-type transistor. Alternatively, the third switching transistor M3 is a P-type transistor and the fourth switching transistor M4 is an N-type transistor.

It should be noted that in the case where the voltage of the data signal DA is a voltage corresponding to a high gray scale, the fourth switching transistor M4, for example, of a P-type, is turned on, so as to transmit the data signal DA to the gate electrode G of the drive transistor M0, so that the voltage of the data signal DA can be prevented from being influenced by the threshold voltage of the third switching transistor M3, for example, of an N-type. In the case where the voltage of the data signal DA is a voltage corresponding to a low gray scale, the third switching transistor M3, for example, of an N-type, is turned on, so as to transmit the data signal DA to the gate electrode G of the drive transistor M0, so that the voltage of the data signal DA can be prevented from being influenced by the threshold voltage of the fourth switching transistor M4, for example, of a P-type. In this way, the range of the voltage input to the gate electrode G of the drive transistor M0 can be expanded.

It should be noted that in the embodiments of the present disclosure, the display panel may include more components, but is not limited to the cases illustrated in FIGS. 6-11B, which may be determined according to actual requirements, such as the functions desired to be implemented, and the embodiments of the present disclosure are not limited thereto.

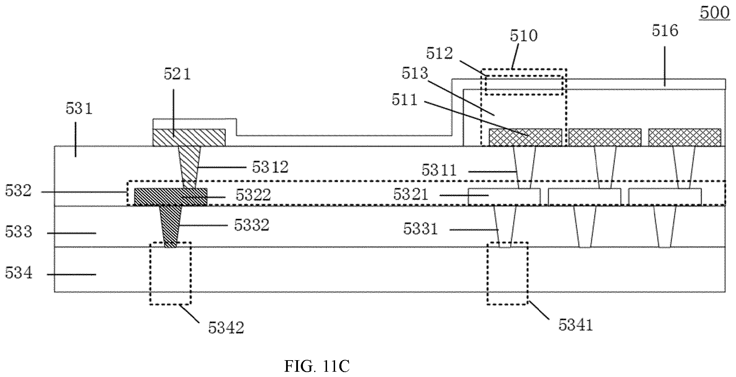

FIG. 11C is a schematic cross sectional view of a display panel provided by at least one embodiment of the present disclosure. For example, a display panel 500 may be implemented as an organic light emitting diode display panel, a light emitting substrate (e.g., a backlight), or the like. The display panel 500 includes an array region and a peripheral region surrounding the array region. The array region includes a plurality of light emitting sub-units 510, and the peripheral region includes a conductive ring 521 (e.g., a cathode ring) arranged around the array region. For example, the peripheral region also includes other regions (e.g., a bonding region) outside the conductive ring 521.

As illustrated in FIG. 11C, each of the plurality of light emitting sub-units 510 includes a first drive electrode 511, a second drive electrode 512, and a light emitting layer 513 sandwiched between the first drive electrode 511 and the second drive electrode 512. For example, the first drive electrode 511 and the second drive electrode 512 are configured to apply a light-emitting drive voltage (apply the light-emitting drive voltage to the light emitting layer 513), so that the light emitting layer 513 emits light, and the intensity of the light corresponds to the value of the light-emitting drive voltage.

For example, as illustrated in FIG. 11C, the first drive electrode 511 and the second drive electrode 512 are an anode (e.g., connected to the second voltage terminal through the pixel circuit) and a cathode (e.g., directly connected to the first voltage terminal), respectively. For example, the first drive electrode 511 and the conductive ring 521 are provided in a same structural layer. For example, the same conductive layer (e.g., a single conductive layer) may be patterned by using the same patterning process to obtain the first drive electrode 511 and the conductive ring 521.

For example, as illustrated in FIG. 11C, the second drive electrodes 512 of the plurality of light emitting sub-units 510 are integrated to form a common electrode layer 516 (e.g., a cathode layer). The common electrode layer 516 extends from the array region to the peripheral region, and the common electrode layer 516 overlaps the conductive ring 521 and is electrically connected to the conductive ring 521 directly.

For example, as illustrated in FIG. 11C, the display panel 500 further includes a first insulating layer 531, an intermediate conductive layer 532, a second insulating layer 533, and a drive backplane 534. The drive backplane 534 includes a silicon substrate, and pixel circuits included in pixel units are manufactured in the silicon substrate. For example, the drive transistor M0, the third switching transistor M3, the fourth switching transistor M4, the storage capacitor Cst, and the like, which are included in the pixel circuits, are formed in the silicon substrate, and are electrically connected to the light emitting elements or other functional circuits through vias, conductive layers, and the like, as described below. Also, the first switching transistor M1 and the second switching transistor M2 included in the voltage control circuit are also formed in the silicon substrate. The silicon substrate may be a bulk silicon substrate (wafer) or a silicon-on-insulator (SOI) substrate, and the embodiments of the present disclosure are not limited thereto. For example, as illustrated in FIG. 11C, the first insulating layer 531, the intermediate conductive layer 532, the second insulating layer 533, and the drive backplane 534 are sequentially arranged in a direction perpendicular to the drive backplane 534, and compared with the drive backplane 534, the first insulating layer 531 is closer to the first drive electrode 511.

For example, as illustrated in FIG. 11C, the first insulating layer 531 includes a first via 5311 and a second via 5312, and the intermediate conductive layer 532 includes a first conductive component 5321 and a second conductive component 5322. The first drive electrode 511 is electrically connected to the first conductive component 5321 through the first via 5311, and the second drive electrode 512 is electrically connected to the second conductive component 5322 through the first conductive ring 521 and the second via 5312.

For example, as illustrated in FIG. 11C, the second insulating layer 533 includes a third via 5331 and a fourth via 5332. The first drive electrode 511 is electrically connected to a first region 5341 (including a pixel circuit) of the drive backplane 534 through the first via 5311, the first conductive component 5321, and the third via 5331. The second drive electrode 512 (the common electrode layer 516) is electrically connected to a second region 5342 (including power supply voltage lines) of the drive backplane 534 through the first conductive ring 521, the second via 5312, the second conductive component 5322, and the fourth via 5332. Thus, the first region 5341 of the drive backplane 534 is configured to supply a second power supply voltage to the first drive electrode 511, and the second region 5342 of the drive backplane 534 is configured to supply a first power supply voltage to the second drive electrode 512. For example, the second power supply voltage is greater than the first power supply voltage.

For example, by providing the conductive ring 521 (e.g., cathode ring), the electrical connection performance between the common electrode layer 516 (e.g., cathode layer) and the second conductive component 5322 can be improved.

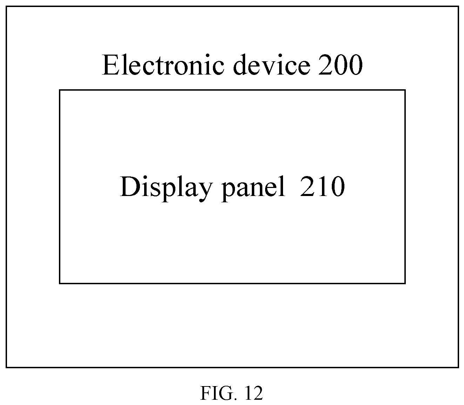

FIG. 12 is a schematic block diagram of an electronic device 200 provided by at least one embodiment of the present disclosure. The electronic device 200 includes a display panel 210, which may be the display panel according to any embodiment of the present disclosure. The electronic device 200 can be any electronic device having a display function, such as a smart phone, a tablet computer, a liquid crystal television, VR glasses, etc.

The technical effects and detailed description of the electronic device may be referred to the above description on the temperature compensation method of the display panel and the display panel, which are not repeated here.

For the present disclosure, the following statements should be noted.
(1) The accompanying drawings involve only the structure(s) in connection with the embodiment(s) of the present disclosure, and other structure(s) can be referred to common design(s).
(2) In case of no conflict, the embodiments of the present disclosure and features in the embodiments may be combined with each other to obtain new embodiments.

What are described above are related to the specific implementations of the present disclosure only and not limitative to the scope of the disclosure, and the scope of the disclosure is defined by the accompanying claims.

## Claims

1. A temperature compensation method for a display panel, wherein the display panel comprises a pixel array, the pixel array comprises a pixel unit, the pixel unit comprises a light emitting element, a first voltage terminal, and a second voltage terminal, the first voltage terminal is configured to receive a first power supply voltage, the second voltage terminal is configured to receive a second power supply voltage, the pixel unit is configured to drive the light emitting element to emit light based on the first power supply voltage and the second power supply voltage that are received, and the temperature compensation method comprises:
setting a voltage difference between the second power supply voltage and the first power supply voltage as a first voltage difference, so as to enable a temperature of the display panel to rise; and
setting the voltage difference between the second power supply voltage and the first power supply voltage as a second voltage difference after the temperature of the display panel rises,
wherein the first voltage difference is greater than the second voltage difference.

2. The temperature compensation method according to claim 1, wherein setting the voltage difference between the second power supply voltage and the first power supply voltage as the first voltage difference, so as to enable the temperature of the display panel to rise, comprises:
setting the first power supply voltage from an initial voltage value to a first voltage value, so as to enable the temperature of the display panel to rise, wherein the initial voltage value is greater than the first voltage value; and
setting the voltage difference between the second power supply voltage and the first power supply voltage as the second voltage difference after the temperature of the display panel rises comprises:
setting the first power supply voltage from the first voltage value to a second voltage value after the temperature of the display panel rises, wherein the first voltage value is less than the second voltage value.

3. The temperature compensation method according to claim 2, further comprising:
detecting a temperature variation amount of the temperature of the display panel relative to a first temperature value when the first power supply voltage is at the second voltage value, and compensating a voltage value of the first power supply voltage based on the temperature variation amount that is detected, so that the temperature of the display panel is maintained at the first temperature value.

4. The temperature compensation method according to any one of claims 1-3, further comprising:
obtaining a data signal based on a predetermined gamma code, so that the display panel displays under drive of the data signal, the first power supply voltage, and the second power supply voltage.

5. The temperature compensation method according to claim 2 or 3, wherein the first voltage value and the second voltage value are both negative values.

6. The temperature compensation method according to claim 5, wherein a ratio of the second voltage value to the first voltage value ranges from 25% to 40%.

7. The temperature compensation method according to any one of claims 2-3 and 5-6, wherein, when the first power supply voltage is maintained at the first voltage value, the temperature of the display panel rises to a second temperature value.

8. The temperature compensation method according to claim 7, wherein a ratio of the second temperature value to the first temperature value ranges from 90% to 110%.

9. The temperature compensation method according to claim 3, wherein compensating the voltage value of the first power supply voltage based on the temperature variation amount that is detected comprises:
converting the temperature variation amount that is detected into a voltage compensation amount, and generating, based on the voltage compensation amount, a compensation signal which is used for compensating the first power supply voltage, so that the voltage value of the first power supply voltage is adjusted.

10. The temperature compensation method according to any one of claims 1-9, wherein the temperature of the display panel is detected by a temperature sensor which is provided in the display panel.

11. A display panel, comprising a pixel array and a first power supply voltage providing circuit,
wherein the pixel array comprises a pixel unit, the pixel unit comprises a light emitting element, a first voltage terminal, and a second voltage terminal, the first voltage terminal is configured to receive a first power supply voltage, the second voltage terminal is configured to receive a second power supply voltage, and the pixel unit is configured to drive the light emitting element to emit light based on the first power supply voltage and the second power supply voltage that are received,
the first power supply voltage providing circuit is configured to set a voltage difference between the second power supply voltage and the first power supply voltage as a first voltage difference to enable a temperature of the display panel to rise, and to set the voltage difference between the second power supply voltage and the first power supply voltage as a second voltage difference after the temperature of the display panel rises, and
the first voltage difference is greater than the second voltage difference.

12. The display panel according to claim 11, further comprising a temperature compensation circuit, wherein the temperature compensation circuit comprises:
a temperature detection unit, configured to detect a temperature variation amount of the temperature of the display panel relative to a first temperature value and output a voltage value corresponding to the temperature variation amount,
a temperature conversion unit, configured to convert the voltage value corresponding to the temperature variation amount into a voltage compensation amount, and
a compensation signal generating unit, configured to process the voltage compensation amount to generate a compensation signal which is used for compensating the first power supply voltage, and provide the compensation signal to the first power supply voltage providing circuit; and
wherein the first power supply voltage providing circuit is further configured to adjust a voltage value of the first power supply voltage based on the compensation signal.

13. The display panel according to claim 12, wherein the temperature detection unit comprises a temperature sensor.

14. The display panel according to any one of claims 11-13, wherein the display panel comprises a silicon-based organic light emitting diode display panel or a silicon-based quantum dot light emitting diode display panel.

15. The display panel according to claim 14, further comprising an array substrate,
wherein the array substrate comprises a silicon substrate, and the pixel unit further comprises a pixel circuit which is electrically connected to the light emitting element, and
the pixel circuit is provided on the silicon substrate.

16. The display panel according to claim 15, wherein the first power supply voltage providing circuit is provided on the silicon substrate.

17. An electronic device, comprising the display panel according to any one of claims 11-16.
